(19) Europäisches Patentamt / European Patent Office / Office européen des brevets

(11) **EP 3 803 432 B1**

(12) **EUROPÄISCHE PATENTSCHRIFT**

(45) Veröffentlichungstag und Bekanntmachung des Hinweises auf die Patenterteilung:
**19.10.2022** **Patentblatt 2022/42**

(21) Anmeldenummer: **19726636.4**

(22) Anmeldetag: **22.05.2019**

(51) Internationale Patentklassifikation (IPC):
**G01R 33/567** (2006.01)     **G01R 33/565** (2006.01)

(52) Gemeinsame Patentklassifikation (CPC):
**G01R 33/5676; G01R 33/56509**

(86) Internationale Anmeldenummer:
**PCT/EP2019/063175**

(87) Internationale Veröffentlichungsnummer:
**WO 2019/224229 (28.11.2019 Gazette 2019/48)**

(54) **VERFAHREN ZUR MESSUNG VON BEWEGUNGEN EINES ABZUBILDENDEN OBJEKTES BEI EINEM MEDIZINISCHEN BILDGEBUNGSVERFAHREN**

METHOD FOR MEASURING MOVEMENTS OF AN OBJECT TO BE IMAGED IN A MEDICAL IMAGING METHOD

PROCÉDÉ DE MESURE DE MOUVEMENTS D'UN OBJET À IMAGER DANS UN PROCÉDÉ D'IMAGERIE MÉDICALE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.05.2018 DE 102018208220**

(43) Veröffentlichungstag der Anmeldung:
**14.04.2021 Patentblatt 2021/15**

(73) Patentinhaber: **Forschungszentrum Jülich GmbH 52425 Jülich (DE)**

(72) Erfinder:
• **BUSCHBECK, Richard**
  **50825 Köln (DE)**
• **SHAH, Nadim Joni**
  **52428 Jülich (DE)**

(74) Vertreter: **dompatent von Kreisler Selting Werner - Partnerschaft von Patent- und Rechtsanwälten mbB
Deichmannhaus am Dom
Bahnhofsvorplatz 1
50667 Köln (DE)**

(56) Entgegenhaltungen:
• **ULLISCH M.G. ET AL.: "Rigid Body Motion Detection with Lissajous Navigator Echoes", PROCEEDINGS OF THE INTERNATIONAL SOCIETY FOR MAGNETIC RESONANCE IN MEDICINE, 17TH SCIENTIFIC MEETING & EXHIBITION, 8. April 2009 (2009-04-08), Seite 4650, XP040611881, Hawaii, USA**
• **ANDREU F. COSTA ET AL: "Using the axis of rotation of polar navigator echoes to rapidly measure 3D rigid-body motion", MAGNETIC RESONANCE IN MEDICINE., Bd. 53, Nr. 1, Januar 2005 (2005-01), Seiten 150-158, XP055608814, US ISSN: 0740-3194, DOI: 10.1002/mrm.20306**
• **FU Z.W. ET AL.: "Optimization of Orbital Navigator Echo Technique in Motion Measurement of MR Imaging", PROCEEDINGS OF THE INTERNATIONAL SOCIETY FOR MAGNETIC RESONANCE IN MEDICINE, SMR SECOND MEETING, 6. August 1994 (1994-08-06), XP040651451, San Fracncisco, USA**
• **YEN Y-F.: "3D Rotation Matching Using Spherical Harmonic Transformation of k-Space Navigator", PROCEEDINGS OF THE INTERNATIONAL SOCIETY FOR MAGNETIC RESONANCE IN MEDICINE, 12TH SCIENTIFIC MEETING & EXHIBITION, 15. Mai 2004 (2004-05-15), Seite 2154, XP040592095, Kyoto, Japan**

- **ULLISCH M.G. ET AL.: "Towards Lissajous navigator-based motion correction for MR-PET", PROCEEDINGS OF THE INTERNATIONAL SOCIETY FOR MAGNETIC RESONANCE IN MEDICINE, JOINT ANNUAL MEETING ISMRM-ESMRMB, 1. Mai 2010 (2010-05-01), Seite 3060, XP040614509, Sweden**
- **RICHARD P. BUSCHBECK ET AL: "3D rigid-body motion information from spherical Lissajous navigators at small k-space radii: A proof of concept", MAGNETIC RESONANCE IN MEDICINE., Bd. 82, Nr. 4, 26. Juni 2019 (2019-06-26), Seiten 1462-1470, XP055608840, US ISSN: 0740-3194, DOI: 10.1002/mrm.27796**
- **WELCH E B ET AL: "SPHERICAL NAVIGATOR ECHOES FOR FULL 3D RIGID BODY MOTION MEASUREMENT IN MRI", MAGNETIC RESONANCE IN MEDICINE, JOHN WILEY & SONS, INC, US, Bd. 47, Nr. 1, 2002, Seiten 32-41, XP001112345, ISSN: 0740-3194, DOI: 10.1002/MRM.10012 in der Anmeldung erwähnt**

**Beschreibung**

**Gebiet der Erfindung**

Die Erfindung bezieht sich auf ein Verfahren zur Bestimmung von Bewegungen eines abzubildenden Objektes bei einem medizinischen Bildgebungsverfahren, das mindestens eine Magnetresonanztomographie (MRT) beinhaltet, einen entsprechend eingerichteten Magnetresonanztomographen und ein zugehöriges Computerprogrammprodukt.

**Hintergrund der Erfindung**

Als Navigator-Scans werden kurze Zwischenscans während einer MRT-Untersuchung bezeichnet, die Teile des k-Raums auslesen. Im Gegensatz zu externen Geräten zur Bewegungsmessung, benötigen Navigatoren ausschließlich die Technik, die ohnehin in jedem Magnetresonanztomographen oder MRT-Scanner verbaut ist. Navigatoren gelten daher als sehr praxistauglich im klinischen Alltag.

Bei sphärischen Navigatoren wird die Oberfläche einer Kugel im k-Raum ganz oder teilweise abgetastet. Die Kugel wird dabei durch ihren Radius charakterisiert, der durch den Absolutbetrag $k_r$ des Wellenvektors k gegeben ist. Das abzubildende Objekt (zum Beispiel das Hirn eines Patienten) wird dabei in Hinblick auf die vernachlässigbaren Verformungen während der MRT-Untersuchung als starrer Körper angenähert. Für die schnelle und simultane Messung von Bewegungen eines starren Körpers mit 6 Freiheitsgraden (drei Rotationsfreiheitsgrade und drei Translationsfreiheitsgrade) kennt der aktuelle Stand der Technik zwei grundsätzliche Arten von sphärischen Navigatoren: 1. Helikale Spiral-Navigatoren und 2. Lissajous-Navigatoren. Bei helikalen Spiral-Navigatoren wird die Oberfläche der k-Raum-Kugel mit Radius $k_r$ auf helikalen Spiralen abgetastet. Die Trajektorie beginnt üblicherweise am Äquator der Sphäre und schraubt sich dann in Richtung Pol. Diese Trajektorie wird für beide Hemisphären wiederholt. Bei Lissajous-Navigatoren wird die Sphäre auf einer 3D-Lissajous-Figur abgetastet.

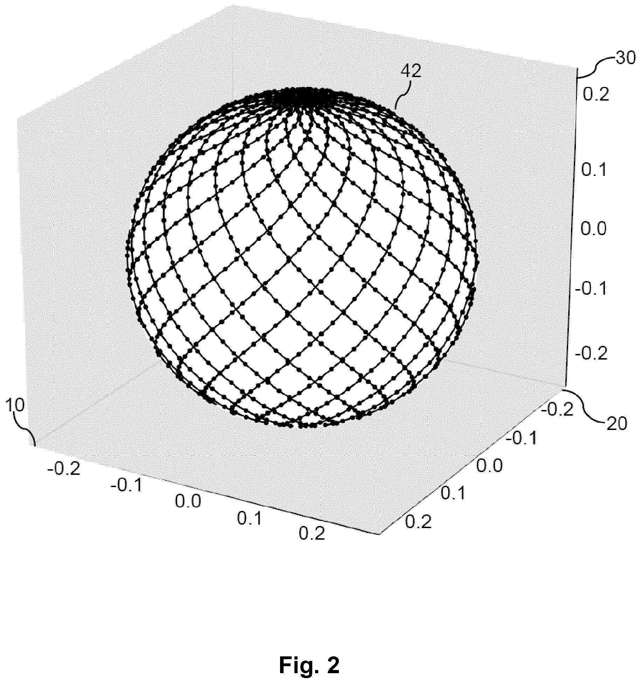

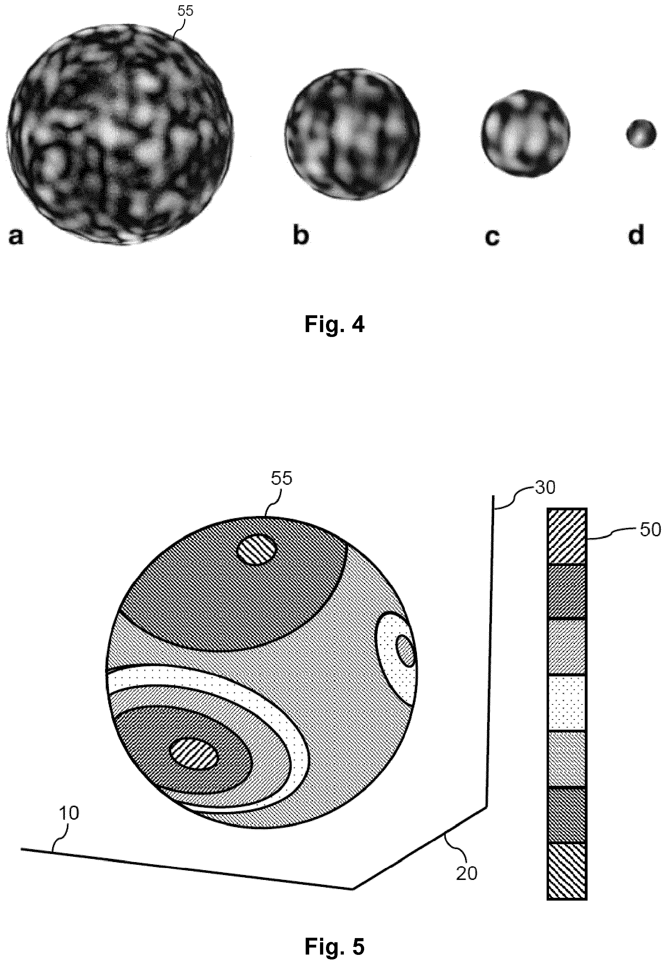

Die wissenschaftliche Veröffentlichung von Welch et al. (Welch, E.B., Manduca, A., Grimm, R.C., Ward, H.A. and Jack Jr, C.R .. Spherical navigator echoes for full 3D rigid body motion measurement in MRI. Magnetic Resonance in Medicine 2002;47:32-41.) beschreibt die Verwendung von helikalen Spiral-Navigatoren zur Bestimmung von Bewegungen und insbesondere Rotationen eines zu scannenden Objektes bei der Magnetresonanztomographie. Die Arbeit von Welch et al. beschreibt im Zusammenhang mit der Fig. 2 insbesondere den Zielkonflikt der Detaillierung der Signalamplituden, die insbesondere zur Bestimmung einer Rotation erforderlich ist und des zugehörigen Signal-Rausch-Verhältnisses (SNR). Die zuvor genannte Fig. 2 der Veröffentlichung von Welch et al. wird als Fig. 4 im weiteren Verlauf näher diskutiert.

Ausgehend von der Arbeit von Welch et al. diskutiert die Dissertation von Marcus Görge Ullisch "Eine navigator-basierte Methode zur Bewegungskorrektur starrer Körper in der Magnet-Resonanz-Tomographie" aus dem Jahre 2012 (http://publications.rwth-aachen.de/record/82888?ln=de) die Verwendung von sphärischen Lissajous-Navigatoren insbesondere für die Bestimmung von Rotationen. Auch diese Arbeit bestätigt den von Welch beschriebenen Zielkonflikt.

Aus der weiteren wissenschaftlichen Veröffentlichung von Yen Y-F, 3D Rotation Matching Using Spherical Harmonic Transformation of k-Space Navigator, Proceedings of the International Society for magnetic resonance in medicine, 12th Scientific Meeting & Exhibition, 15. Mai 2004, Seite 2154 beschreibt für orbitale Navigatoren ein dreidimensionales Rotationsmatching auf der Basis von Kugelflächenfunktionen.

**Zusammenfassung der Erfindung**

Es ist eine Aufgabe der vorliegenden Erfindung ein verbessertes Verfahren zur Bestimmung von Bewegungen eines abzubildenden Objektes vorzugsweise während der Aufnahme von Bilddaten durch einen Magnetresonanztomographen zur Verfügung zu stellen.

Gemäß einem ersten Aspekt wird ein Verfahren zur Bestimmung von Bewegungen eines abzubilden Objektes bei einem medizinischen Bildgebungsverfahren, das mindestens eine Magnetresonanztomographie beinhaltet, zur Verfügung gestellt. Das Verfahren umfasst die folgenden Schritte:

- Bestimmung erster Koeffizienten einer mathematischen Transformation basierend auf durch einen Magnetresonanztomographen aufgenommenen ersten Navigatordaten des Objektes, wobei die ersten Navigatordaten Daten eines ersten sphärischen Lissajous-Navigators im k-Raum mit $k_r<0,2$/cm, bevorzugt $k_r<0,15$/cm und besonders bevorzugt $k_r<0,1$/cm sind, wobei $k_r$ den Absolutbetrag des Wellenvektors k bezeichnet,

- Bestimmung zweiter Koeffizienten einer mathematischen Transformation basierend auf durch den Magnetresonanztomographen aufgenommenen zweiten Navigatordaten des Objekts, wobei die zweiten Navigatordaten Daten eines zweiten sphärischen Lissajous-Navigators im k-Raum mit $k_r<0,2$/cm, bevorzugt $k_r<0,15$/cm und besonders bevorzugt $k_r<0,1$/cm sind, wobei $k_r$ den Absolutbetrag des Wellenvektors k bezeichnet,

wobei die ersten Koeffizienten erste Koeffizienten von Kugelflächenfunktionen sind, und
wobei die zweiten Koeffizienten zweite Koeffizienten von Kugelflächenfunktionen sind,
wobei die ersten Navigatordaten erste Signalamplituden umfassen, und die zweiten Navigatordaten zweite Signalamplituden umfassen, wobei die ersten Signalamplituden und die zweiten Signalamplituden jeweils auf ein reguläres Gitter oder auf beliebigen Punkten, wie insbesondere zufällig verteilt, auf einer Kugeloberfläche interpoliert werden,

- Berechnung einer Rotation des Objektes mittels einer mathematischen Optimierung basierend auf den ersten Koeffizienten und den zweiten Koeffizienten.

Das Verfahren umfasst optional die weiteren Schritte:

- Aufnahme der erster Navigatordaten des Objektes durch den Magnetresonanztomographen,
- Aufnahme der zweiten Navigatordaten durch den Magnetresonanztomographen.

Das Verfahren ermöglicht im Gegensatz zum oben angeführten Stand der Technik insbesondere die Bestimmung bzw. Messung von Rotationen des abzubildenden Objektes bei kleinen Absolutbeträgen des Wellenvektors. Es werden insbesondere die folgenden Nachteile der vorbekannten Verfahren vermieden:

- die im Stand der Technik (siehe insbesondere die oben zitierte Arbeit von Welch et al.) beschriebenen Musterabgleich-Algorithmen zur Bestimmung der Rotation sind rechenaufwändig, was zu langen Latenzzeiten zwischen dem Aufnehmen des Navigators und der vollständigen Berechnung der Bewegungsparameter führt.
- Musterabgleich-Algorithmen benötigen zudem einen ausreichend hohen Merkmalreichtum in der Signalmagnitude um genau zu funktionieren. Ein solch hoher Merkmalreichtum ist nur durch das Messen von Navigatoren bei sehr großen $k_r$ größer 0,34/cm zu erreichen. Bei großen $k_r$ ist jedoch das SNR niedrig, was ebenfalls problematisch sein kann. Daher ist, wie bei der Darstellung des Stands der Technik angesprochen, der optimale $k_r$ ein Kompromiss aus Merkmalreichtum und SNR.
- Ein weiteres Problem bei großen $k_r$ ist, dass nur kleine Translationen ohne weiteres aus den Daten bestimmt werden können. Die Spanne der Translationen, die direkt aus den Navigatordaten bestimmt werden kann, ist gegeben durch $0,5/k_r$. Ist die Translation größer, so muss zunächst ein Phase-Unwrap-Algorithmus angewendet werden, was den Rechenaufwand und den damit verbundenen Zeitaufwand weiter erhöht.
- Helikale Spiral-Navigatoren nutzen, wie im oben genannten Stand der Technik beschrieben, k-Raum-Trajektorien, die problematische Gradienteneigenschaften (hohe slew rates und Amplituden) insbesondere nahe den Polen mit sich bringen.
- Helikale Spiral-Navigatoren benötigen zwei Anregungspulse, was die Aufnahmedauer verlängert und stark in den magnetischen Steady State der Hauptsequenz eingreift. Die oben genannte Arbeit von Welch et. al. beschreibt zum Beispiel Aufnahmedauern für helikale Spiral-Navigatoren von mehr als 25ms.
- Helikale Spiral-Navigatoren können nicht bei sehr kleinen $k_r$ gemessen werden, da sonst die Amplitude ihrer z-Gradienten so klein wird (gleiche Größenordnung wie magnetische Suszeptibilitätsgradienten), dass die k-Raum-Trajektorie sehr ungenau und damit unbrauchbar wird. Die benötigten großen $k_r$ tragen zu den langen Aufnahmedauern über 25ms bei.

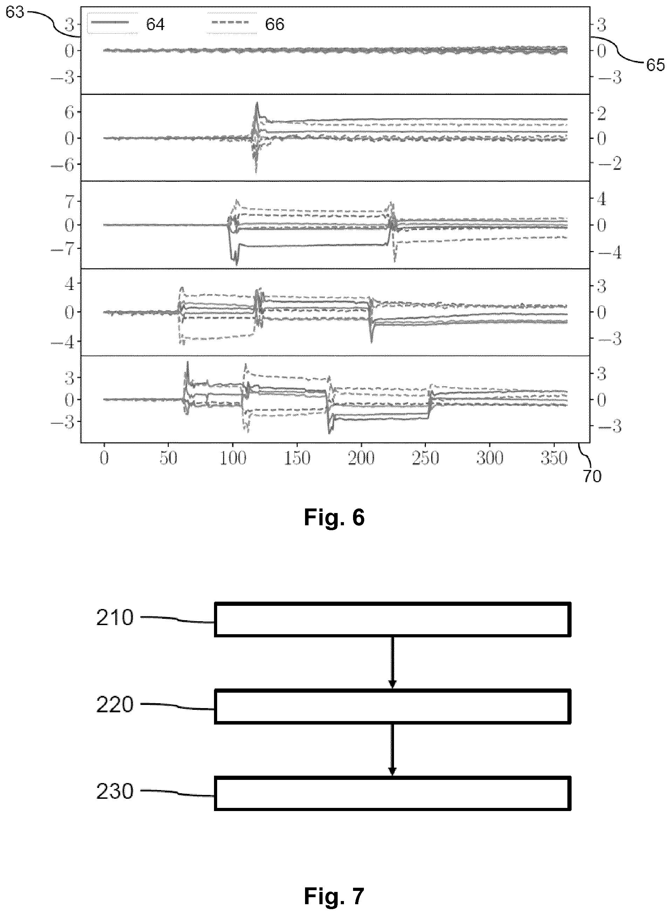

Das beanspruchte Verfahren ermöglicht es durch die kleinen k-Raum Radien $k_r$, die mittels des ersten und zweiten sphärischen Lissajous-Navigators aufgenommen werden, erste und zweite Navigatordaten in sehr kurzen Messzeiten aufzunehmen, ohne dass die Genauigkeit der Bestimmung der Bewegungsdaten (Rotation sowie gegebenenfalls Translation) darunter leidet. Der in der Arbeit von Welch et al. beschriebene Zielkonflikt wird somit aufgelöst. Die Bewegung eines abzubilden Objektes (zum Beispiel das Hirn eines Patienten) kann somit mit hoher Genauigkeit und gleichzeitig schneller (und damit auch mit verbesserter zeitlicher Auflösung) erfolgen. Die Messung der Bewegung (Rotation und gegebenenfalls Translation) des abzubildenden Objektes zwischen zwei Navigatorscans (Aufnahme erster und zweiter Navigatordaten) kann dabei zum Beispiel zur Echtzeit-Kompensation der zwischen den beiden Navigatorscans aufgenommenen MRT-Bilddaten des abzubildenden Objektes verwendet werden. Alternativ kann die berechnete Rotation und gegebenenfalls die Translation auch zur nachträglichen Bearbeitung der MRT-Bilddaten in einem externen Rechner oder Rechnersystem verwendet werden. Die Bewegungsdaten können z.B. bei MR-PET Messungen auch ohne Aufnahme von MRT-Bilddaten aufgenommen werden. Die Bewegungsdaten können in diesem Fall zur Bewegungskorrektur der PET-Messungen verwendet werden. Die Bestimmung der Translation kann dabei mittels der vorbekannten Verfahren erfolgen, wie sie zum Beispiel in den oben genannten Arbeiten von Welch et al. (siehe insbesondere das Kapitel "Determination of Translation" auf Seite 33 rechte Spalte, das durch die Bezugnahme zum Bestandteil der Ausführungen wird) und Ullisch (siehe insbesondere Kapitel 4.3 ab Seite 60, das durch die Bezugnahme zum Bestandteil der Ausführungen wird) beschrieben werden. Zwei, drei, vier oder eine Vielzahl von sphärischen Lissajous-Navigatoren können verwendet werden, um den zeitlichen Verlauf eine Bewegung des Objektes während eines MRT-Scans zu bestimmen (siehe zum Beispiel Fig. 6).

Die ersten Navigatordaten umfassen erste Signalamplituden, und die zweiten Navigatordaten umfassen zweite Signalamplituden, wobei die ersten Signalamplituden und die zweiten Signalamplituden jeweils auf ein reguläres Gitter (zum Beispiel Gitter aus Längen- und Breitengraden) auf einer Kugeloberfläche interpoliert werden. Die ersten Koeffizienten und die zweiten Koeffizienten können als Alternative zum regulären Gitter auch auf beliebigen Punkten (z.B. zufällig verteilt) auf der Kugeloberfläche berechnet bzw. interpretiert werden. Die Umsetzung der Berechnung auf einem regulären Gitter hat sich allerdings in Hinblick auf die benötigte Rechenzeit auf gängigen Rechnern oder Rechnersystemen als vorteilhaft erwiesen.

Der erste Lissajous-Navigator und der zweite Lissajous-Navigator sind vorzugsweise durch die k-Raum-Trajektorie

$$k_x = k_r \sin(\omega_\theta t) * \cos(\omega_\phi t)$$

$$k_y = k_r \sin(\omega_\theta t) * \sin(\omega_\phi t)$$

$$k_z = k_r \cos(\omega_\theta t)$$

bestimmt ist, wobei t die Zeit ist und $\omega_\theta = n_\theta * 2 * \pi / \delta_{nav}$ und $\omega_\phi = n_\phi * 2 * \pi / \delta_{nav}$ sind, wobei $\delta_{nav}$ die Netto-Navigatordauer ist und $n_\theta$ und $n_\phi$ ganze Zahlen sind. Die Netto-Navigatordauer ist kleiner 20 ms, vorzugsweise kleiner 15 ms und besonders bevorzugt kleiner 10 ms. $n_\theta$ und $n_\phi$ werden vorzugsweise zwischen 5 und 25 gewählt. Die Netto-Navigatordauer bezeichnet dabei die Zeit, in der sich die k-Raum-Trajektorie auf der Kugeloberfläche befindet. Die Werte für $n_\theta$ und $n_\phi$ bestimmen die Form und Dichte des Netzes, das von der Lissajous-Figur auf der Kugeloberfläche aufgespannt wird. Werte kleiner 5 ermöglichen keine ausreichend dichte Abdeckung der Oberfläche, die für eine hohe Genauigkeit bei der Bestimmung der Rotation nötig wäre. Werte größer 25 ergeben hingegen keine wesentliche Verbesserung bei der Bestimmung der Rotation führen jedoch zu erheblich erhöhtem Zeitaufwand für die Messung des Navigators.

Das Verfahren ermöglicht es, insbesondere durch die kleinen Radien $k_r$ im k-Raum, die ersten und zweiten Koeffizienten schnell und mit großer Genauigkeit (bedingt durch das hohe Signal-Rausch-Verhältnis und die verminderten $T_2^*$-Effekte) basierend auf den Messpunkten auf der Kugeloberfläche zu bestimmen. Es werden vorzugsweise weniger als 3000 Messpunkte, vorzugsweise weniger als 2000 Messpunkte und besonders bevorzugt weniger als 1000 Messpunkte verwendet, um die ersten und zweiten Koeffizienten mit ausreichender Genauigkeit zu bestimmen. Während der Netto-Navigationsdauer können auch deutlich mehr (z.B. 10000) sehr kurze Messpunkte aufgenommen werden, die entweder zusammengefasst oder selektiert werden, so dass am Ende z.B. nur 2000 Messpunkte zur Bestimmung der Koeffizienten verwendet werden.

Das zuvor beschriebene Verfahren ermöglicht es außerdem den ersten und den zweiten Navigator mit jeweils nur einem Anregungspuls, also einem Hochfrequenzanregungspuls der HF-Spule des Magnetresonanztomographen zu bestimmen. Auch dies mindert die Messzeit für die sphärischen Navigatoren.

Die Rotation des abzubildenden Objektes wird vorzugsweise mittels eines Rotationtheorems der Kugelflächenfunktionen bestimmt.

Die Rotation des Objektes wird vorzugsweise derart bestimmt, dass die Rotation des Objektes mittels des Rotationstheorems die ersten Koeffizienten $\hat{f}_{lm}$ der Kugelflächenfunktionen optimal in die zweiten Koeffizienten der Kugelflächenfunktionen überführt.

Die Rotation wird dabei vorzugsweise derart berechnet, dass sich die zweiten Koeffizienten der Kugelflächenfunktionen $\hat{f}_{lm}^{g}$ gemäß

$$\hat{f}_{lm}^{g} = e^{-im(\gamma + \pi/2)} \sum_{p=-l}^{l} e^{-ip(\alpha + \pi/2)} \hat{f}_{lp} \sum_{k=-l}^{l} e^{-ik(\beta + \pi)} P_l^{pk}(0) P_l^{km}(0)$$

aus den ersten Koeffizienten der Kugelflächenfunktionen ergeben. Die Winkel $\alpha$, $\beta$ und $\gamma$ bezeichnen Eulerwinkel in der ZYZ-Konvention. Die $P_l^{km}(0)$ bezeichnen generalisierte assoziierte Legendre-Polynome. Die Winkel $\alpha$, $\beta$ und $\gamma$ werden vorzugsweise durch eine Optimierung

$$\min_{\alpha,\beta,\gamma}\left( \sum_{l=1}^{l_{\max}} \sum_{m=0}^{l} |\hat{f}_{lm}^{g} - \hat{f}_{lm}|^2 \right)$$

berechnet. Die generalisierten assoziierten Legendre-Polynome werden zum Beispiel in dem Artikel von Phinney RA, Burridge R. "Representation of the elastic-gravitational excitation of a spherical earth model by generalized spherical harmonics" im Geophysical Journal International 1973; 34: 451-487 beschrieben, der durch Bezugnahme in die Ausführungen aufgenommen wird.

Die hier dargestellte mathematische Beschreibung stellt nur eine von einer Vielzahl von möglichen Darstellungen dar. Neben den Eulerwinkeln in der ZYZ-Konvention sind andere Konventionen möglich. Alternativ lassen sich die zweiten Koeffizienten $\hat{f}_{lm}^{g}$ der Kugelflächenfunktionen auch mittels anderer mathematischer Methoden aus den ersten Koeffizienten der Kugelflächenfunktionen $\hat{f}_{lm}$ berechnen (oder allgemeiner nachfolgende Koeffizienten aus den vorhergehenden Koeffizienten). Beispielhaft sei an dieser Stelle die Berechnung über die Wigner-Rotations-Matrizen $U_l^{pm}$ genannt. Die zweiten oder nachfolgenden Koeffizienten $\hat{f}_{lm}^{g}$ ergeben sich in diesem Fall aus:

$$\hat{f}_{lm}^{g} = \sum_{p=-l}^{l} U_l^{pm}(g)\, \hat{f}_{lp}$$

Die Gewichtungen $U_l^{pm}$ oder Wigner-Rotations-Matrizen sind dabei folgendermaßen mit den generalisierten assoziierten Legendre-Polynomen verknüpft:

$$U_l^{pm}\big(g(\alpha,\beta,\gamma)\big) = e^{-ip\alpha} \cdot P_l^{pm}(\cos\beta) \cdot e^{-im\gamma}.$$

Die Rotation ist auch in diesem Fall wieder über die Eulerwinkel in ZYZ-Konvention definiert. Details bezüglich der Wigner-Rotations-Matrizen finden sich zum Beispiel in Michael A Morrison und Gregory A Parker. "A Guide to Rotations in Quantum Mechanics". In: Australian journal of physics 40.4 (1987), S. 465-498.

Das zuvor beschriebene Verfahren umfasst vorzugsweise den zusätzlichen Schritt, eine Translation des Objektes unmittelbar aus den ersten Navigatordaten und zweiten Navigatordaten zu berechnen. Die Spanne der Translationen, die direkt aus den Navigatordaten bestimmt werden kann, ist aufgrund des kleinen $k_r$ deutlich größer als im angeführten Stand der Technik. In Hinblick auf die zuvor genannte Beschränkung auf Translationen kleiner $0{,}5/k_r$ ist es möglich bei $k_r<0.2/cm$ Translationen von mehr als 2,5cm und vorzugsweise bei $k_r<0.1/cm$ Translationen von mehr als 5 cm ohne Phase-Unwrap-Algorithmus zu berechnen. Dies deckt zum Beispiel bei der Abbildung eines Kopfes in der Regel alle realistischen Translationen ab, so dass in der Regel kein rechenaufwändiger Phase-Unwrap-Algorithmus verwendet werden muss (siehe auch Diskussion der Fig. 6).

Zwischen der Aufnahme der ersten Navigatordaten und der zweiten Navigatordaten werden vorzugsweise Bilddaten des Objektes durch den Magnetresonanztomographen aufgenommen. Mehrere Sequenzen von Bilddaten können somit in Echtzeit oder im Nachhinein durch sukzessive Bestimmung der zwischen den Sequenzen liegenden Rotationen korrigiert werden.

Alternativ oder zusätzlich ist es möglich, dass ein Aufnahmebereich (field-of-view) des Magnetresonanztomographen in Abhängigkeit von der berechneten Rotation und gegebenenfalls Translation in Echtzeit angepasst wird. Die sukzessive Anpassung des Aufnahmebereiches durch zum Beispiel die Anpassung der Magnetfeldgradienten ermöglicht eine weitere Verbesserung der Abbildung des Objektes, da die relative Position des Aufnahmebereichs zur Position des abzubildenden Objektes stabiler ist. Dies verbessert die Qualität die Bildrekonstruktion.

Es ist eine weitere Aufgabe der vorliegenden Erfindung, einen verbesserten Magnetresonanztomographen im Einklang mit Anspruch 10 zur Verfügung zu stellen.

Der Magnetresonanztomograph umfasst eine Vorrichtung zur Erzeugung eines statischen Magnetfeldes (z.B, statische Magnetfeldspulen oder alternativ auch Permanentmagnete), Gradientenspulen sowie eine mit den Gradientenspulen gekoppelte Steuerung der Gradientenspulen zur Erzeugung eines zeitlich veränderlichen Magnetfeldgradienten, Hochfrequenzspulen sowie eine mit den Hochfrequenzspulen gekoppelte Hochfrequenzsteuerung zur Erzeugung von Anregungsimpulsen, eine (vorzugsweise mit einem zu untersuchenden Objekt koppelbare, alternativ eine in den Magnetresonanztomographen integrierte) Empfangsspule, ein Signalverarbeitungssystem, das eingerichtet ist, von der Empfangsspule empfangene Messdaten zu empfangen, sowie ein Steuersystem, das mit der Vorrichtung zur Erzeugung des statischen Magnetfeldes, der Steuerung der Gradientenspulen, der Hochfrequenzsteuerung und dem Signalverarbeitungssystem gekoppelt ist. Der Magnetresonanztomograph ist eingerichtet, erste Navigatordaten des Objektes mittels eines ersten sphärischen Lissajous-Navigators im k-Raum mit $k_r<0,2/cm$, bevorzugt $k_r<0,15/cm$ und besonders bevorzugt $k_r<0,1/cm$ aufzunehmen, wobei $k_r$ den Absolutbetrag des Wellenvektors k bezeichnet, und erste Koeffizienten einer mathematischen Transformation, vorzugsweise erste Koeffizienten von Kugelflächenfunktionen, basierend auf den ersten Navigatordaten zu bestimmen. Der Magnetresonanztomograph ist zudem eingerichtet, zweite und weitere Navigatordaten des Objektes mittels eines zweiten sphärischen Lissajous-Navigators im k-Raum mit $k_r<0,2/cm$, bevorzugt $k_r<0,15/cm$ und besonders bevorzugt $k_r<0,1/cm$ aufzunehmen und zweite sowie weitere Koeffizienten der mathematischen Transformation, vorzugsweise zweite sowie weitere Koeffizienten von Kugelflächenfunktionen, basierend auf den zweiten Navigatordaten zu bestimmen. Der Magnetresonanztomograph ist weiter eingerichtet eine Rotation des Objektes mittels einer mathematischen Optimierung basierend auf den ersten Koeffizienten und den zweiten Koeffizienten zu berechnen.

Das Signalverarbeitungssystem ist eingerichtet, die Koeffizienten zu berechnen. Die Berechnung der Rotation kann dabei mittels eines im Magnetresonanztomographen integrierten Berechnungssystems, zum Beispiel des Signalverarbeitungssystems, erfolgen. Alternativ kann die Berechnung der Rotation in einem vom Magnetresonanztomographen umfassten, externen Berechnungssystem erfolgen.

Die beschriebenen Komponenten des Magnetresonanztomographen sind rein funktionaler Natur. Die verschiedenen Steuerungen können somit zum Beispiel durch eine zentrale Steuerung und entsprechende Programme realisiert sein.

Die Hochfrequenzsteuerung ist eingerichtet, mittels der Hochfrequenzspulen mindestens einen Anregungspuls zur Aufnahme der ersten Navigatordaten und mindestens einen Anregungspuls zur Aufnahme der zweiten Navigatordaten zu erzeugen. Die Steuerung der Gradientenspulen ist eingerichtet, mittels der Gradientenspulen den ersten und den zweiten sphärischen Lissajous-Navigator zur Aufnahme der ersten und der zweiten Navigatordaten zu erzeugen (die k-Raum-Trajektorie zu realisieren). Die Empfangsspule ist eingerichtet, die ersten und die zweiten Navigatordaten aufzunehmen. Die ersten Navigatordaten umfassen erste Signalamplituden, und die zweiten Navigatordaten umfassen zweite Signalamplituden. Das Signalverarbeitungssystem ist eingerichtet, die ersten Navigatordaten und die zweiten Navigatordaten von der Empfangsspule zu empfangen. Das Signalverarbeitungssystem ist weiter erfindungsgemäss eingerichtet, die ersten Signalamplituden und die zweiten Signalamplituden jeweils auf ein reguläres Gitter oder auf beliebigen Punkten, wie insbesondere zufällig verteilt, auf einer Kugeloberfläche zu interpolieren. Das Signalverarbeitungssystem ist weiter eingerichtet, die ersten Koeffizienten von z.B. Kugelflächenfunktionen mittels der ersten Signalamplituden zu berechnen. Das Signalverarbeitungssystem ist schließlich eingerichtet, die zweiten Koeffizienten von z.B. Kugelflächenfunktionen mittels der zweiten Signalamplituden zu berechnen. Die Berechnung der ersten und zweiten Koeffizienten sowie der Rotation bzw. Translation kann alternativ auch im Steuersystem erfolgen.

Der Magnetresonanztomograph ist vorzugsweise eingerichtet, einen Aufnahmebereich zur Bestimmung von Bilddaten des Objektes in Abhängigkeit von der berechneten Rotation bzw. Translation anzupassen.

Gemäß einem weiteren Aspekt wird ein Computerprogrammprodukt zur Verfügung gestellt, welches in Anspruch 12 definiert ist. Das Computerprogrammprodukt umfasst Computer-Code-Mittel, die in einem Speicher einer Ausführungsform des zuvor beschriebene Magnetresonanztomographen oder eines Auswertungsrechners gespeichert werden können. Die Computer-Code-Mittel sind derart ausgestaltet, dass die Verfahrensschritte gemäß einer Ausführungsform des zuvor beschriebenen Verfahrens auf einem Prozessor einer Ausführungsform des zuvor beschriebene Magnetresonanztomographen oder eines Auswertungsrechners ausgeführt werden können.

Insbesondere die Bestimmung der ersten und zweiten Koeffizienten von Kugelflächenfunktionen basierend auf den ersten und zweiten Navigatordaten, sowie die Berechnung der Rotation des Objektes mittels einer mathematischen Optimierung basierend auf den ersten Koeffizienten und den zweiten Koeffizienten kann auf einem externen Auswertungsrechner durchgeführt werden. Die Navigatordaten werden in diesem Fall als Rohdaten in geeigneter Form vom Magnetresonanztomographen an den Auswertungsrechner übermittelt.

Der Speicher umfasst jede geeignete Speichereinrichtung, insbesondere digitale Speichereinrichtungen wie zum Beispiel optische oder Festkörperspeicher. Der Prozessor umfasst jede Art von Mikroprozessor oder Applikationsspezifischem integrierter Schaltkreis (ASIC).

Weitere bevorzugte Ausführungsformen werden im Folgenden beschrieben.

Kurze Beschreibung der Abbildungen

Diese und andere Aspekte der Erfindung werden im Detail in den Abbildungen wie folgt gezeigt.

Fig. 1 zeigt eine Prinzipskizze eines Magnetresonanztomographen
Fig. 2 zeigt eine Prinzipskizze eines sphärischen Lissajous-Navigators
Fig. 3 zeigt einen Verlauf der Gradienten eines sphärischen Lissajous-Navigators
Fig. 4 zeigt Karten von Signalamplituden für verschiedene Werte des Absolutbetrages des Wellenvektors
Fig. 5 zeigt eine Karte von Signalamplituden für einen Absolutbetrag des Wellenvektor $k_r \leq 0.2/cm$
Fig. 6 zeigt Ergebnisse einer Rotations- und Translationsbestimmung
Fig. 7 zeigt eine Prinzipskizze des Verfahrensablaufs

Die Darstellung in den Figuren ist, sofern nicht anders beschrieben, nicht maßstabsgetreu. Die Darstellung in den Figuren ist beispielhaft und in keiner Weise einschränkend zu verstehen.

**Detaillierte Beschreibung der Ausführungsbeispiele**

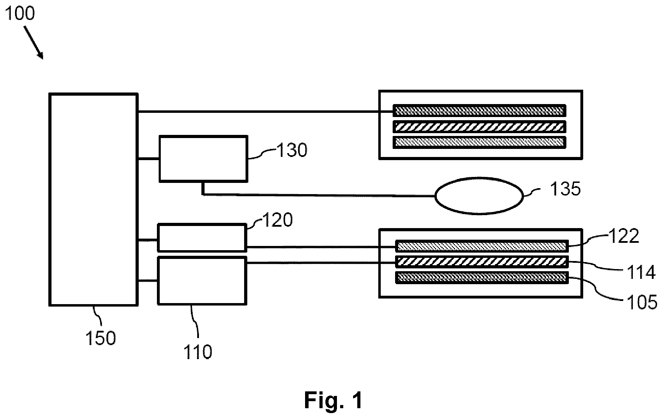

Fig. 1 zeigt eine Prinzipskizze eines Magnetresonanztomographen 100. Der Magnetresonanztomograph 100 umfasst eine Vorrichtung zur Erzeugung eines statischen Magnetfeldes 105 (z.B. statische Magnetfeldspule, Permanentmagnet etc.) zur Erzeugung eines statischen Magnetfelds. Die z.B. statischen Magnetfeldspulen sind mit einem Steuersystem 150 gekoppelt, das eingerichtet ist, das statische Magnetfeld zu steuern. Der Magnetresonanztomographen 100 umfasst weiter Gradientenspulen 114 sowie eine mit den Gradientenspulen 114 gekoppelte Steuerung der Gradientenspulen 110 zur Erzeugung eines zeitlich veränderlichen Magnetfeldgradienten. Der Magnetresonanztomographen 100 umfasst schließlich Hochfrequenzspulen 122 sowie eine mit den Hochfrequenzspulen 122 gekoppelte Hochfrequenzsteuerung 120 zur Erzeugung von Anregungsimpulsen und eine mit einem zu untersuchenden Objekt koppelbare Empfangsspule 135. Ein Signalverarbeitungssystem 130 ist zudem eingerichtet, von der Empfangsspule 135 empfangene Messdaten zu empfangen. Das Steuersystem 150 ist neben den statischen Magnetfeldspulen mit der Steuerung der Gradientenspulen 110, der Hochfrequenzsteuerung 120 und dem Signalverarbeitungssystem 130 gekoppelt. Der Magnetresonanztomograph 100 ist eingerichtet, erste Navigatordaten des Objektes mittels eines ersten sphärischen Lissajous-Navigators im k-Raum mit $k_r < 0,2/cm$, bevorzugt $k_r < 0,15/cm$ und besonders bevorzugt $k_r < 0,1/cm$ aufzunehmen, wobei $k_r$ den Absolutbetrag des Wellenvektors k bezeichnet, und erste Koeffizienten von Kugelflächenfunktionen basierend auf den ersten Navigatordaten zu bestimmen. Der Magnetresonanztomograph 100 ist zudem eingerichtet, zweite Navigatordaten des Objektes mittels eines zweiten sphärischen Lissajous-Navigators im k-Raum mit $k_r < 0,2/cm$, bevorzugt $k_r < 0,15/cm$ und besonders bevorzugt $k_r < 0,1/cm$ aufzunehmen und zweite Koeffizienten von Kugelflächenfunktionen basierend auf den zweiten Navigatordaten zu bestimmen. Der Magnetresonanztomograph 100 ist weiter eingerichtet eine Rotation des Objektes mittels einer mathematischen Optimierung basierend auf den ersten Koeffizienten und den zweiten Koeffizienten zu berechnen.

Die Bestimmung der ersten und zweiten Koeffizienten sowie Berechnung der Rotation kann dabei wahlweise im Signalverarbeitungssystem 130 oder im Steuersystem 150 erfolgen. Der Magnetresonanztomograph 100 umfasst optional eine nicht dargestellte Schnittstelle, die eingerichtet ist, die Navigatordaten ohne weitere Aufbereitung an einen externen Auswertungsrechner bzw. Computersystem zu übermitteln. Der Magnetresonanztomograph 100 umfasst zudem eine nicht dargestellte Nutzerschnittstelle zur Eingabe von Messprogrammen und optional Auswertung von Messergebnissen.

Fig. 2 zeigt eine Prinzipskizze eines sphärischen Lissajous-Navigators 42 im k-Raum mit einem Radius $k_r$ kleiner 0,2/cm. Die Achse $k_x$ ist mit 10, die Achse $k_y$ ist mit 20 und die Achse $k_z$ ist mit 30 bezeichnet. Die k-Raum-Trajektorie des Lissajous-Navigators lässt sich mathematisch in der bereits beschriebenen Form darstellen:

$$k_x = k_r \sin(\omega_\theta t) * \cos(\omega_\phi t)$$

$$k_y = k_r \sin(\omega_\theta t) * \sin(\omega_\phi t)$$

$$k_z = k_r \cos(\omega_\theta t)$$

wobei t die Zeit ist und $\omega_\theta = n_\theta * 2 * \pi / \delta_{nav}$ und $\omega_\phi = n_\phi * 2 * \pi / \delta_{nav}$ sind, wobei $\delta_{nav}$ die bereits erläuterte Netto-Navigatordauer ist, und $n_\theta$ und $n_\phi$ ganze Zahlen sind. Der in der Fig. 2 dargestellte sphärische Lissajous-Navigator 42 ist durch ne=21 und $n_\phi$=20 charakterisiert. Die schwarzen Punkte symbolisieren 2000 Messpunkte, die gleichmäßig auf die Dauer $\delta_{nav}$ des Navigators 42 verteilt sind. Die Punkte sind somit gleichmäßig auf der Lissajous-Trajektorie verteilt und können anschließend auf ein regelmäßiges Gitter entlang der Längen- und Breitengrade der Kugeloberfläche interpoliert werden.

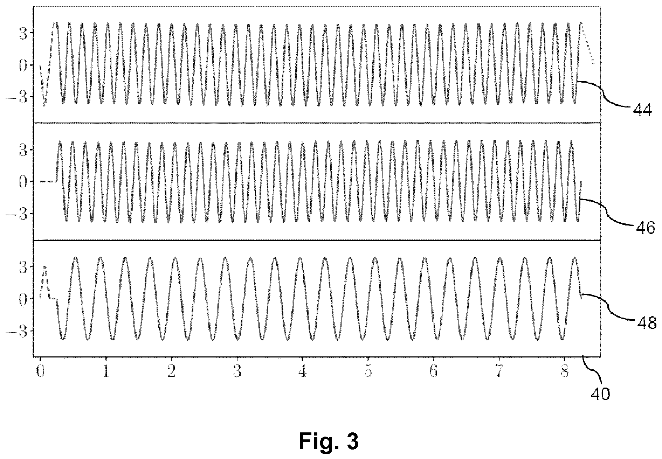

Fig. 3 zeigt einen Verlauf der Magnetfeldgradienten eines Lissajous-Navigators bei $k_r$=0,1/cm und $\delta_{nav}$=8ms. Die Linie 44 zeigt den zeitlichen Verlauf des Gradienten $G_x$ [mT/m] entlang der x-Achse. Die Linie 46 zeigt den zeitlichen Verlauf des Gradienten $G_y$ [mT/m] entlang der y-Achse. Die Linie 48 zeigt den zeitlichen Verlauf des Gradienten $G_z$ [mT/m] entlang der z-Achse. Der Verlauf ist sinusartig auf allen Achsen. Die gestrichelte Linie stellt Anlaufgradienten dar, um die richtige Startposition und -richtung auf der Oberfläche der k-Raum-Sphäre (siehe Fig. 2) zu erreichen. Die gepunktete Linie stellt einen Runterfahrgradienten dar, der je nach Anwendung auch durch einen Crushergradienten ersetzt werden kann.

Fig. 4 zeigt Karten von Signalamplituden 55 für verschiedene Werte des Absolutbetrages des Wellenvektors k. Die Fig. 4 ist, wie bereits zuvor erwähnt, als Fig. 2 in der Arbeit von Welch et al. dargestellt. Die Karten der Signalamplituden 55 sind von links nach rechts in Fig. 4 für a mit einem Radius $k_r$=1/cm, für b mit einem Radius $k_r$=0,63/cm, für c mit einem Radius $k_r$=0,42/cm und für d mit einem Radius $k_r$=0,21/cm erstellt worden. Die Graustufen stellen die Signalamplituden oder Signalmagnituden dar, wobei die Graustufenskalen der vier Abbildungen unterschiedlich normiert sind. Der Merkmalsreichtum der Signalamplituden steigt mit steigendem Radius das SNR wird gleichzeitig aber schlechter. Ein Merkmalsreichtum, der der Darstellung c entspricht, ist allerdings erforderlich, um nach einer Rotation des Objektes die Karten der Signalamplituden 55 mit ausreichender Genauigkeit mittels eines Musterabgleich-Algorithmus ineinander überführen zu können und somit die Rotation zu bestimmen (siehe auch entsprechende Ausführungen in der Arbeit von Welch et al.).

Fig. 5 zeigt eine Karte von Signalamplituden 55 für einen Absolutbetrag des Wellenvektor $k_r \leq 0.2$/cm. Der Merkmalsreichtum ist bei so kleinen k-Raumradien $k_r$ sehr gering, so dass ein Musterabgleich-Algorithmus die Rotation nicht mit ausreichender Genauigkeit berechnen kann. Um die Bewegung zwischen den Aufnahmezeitpunkten zweier Lissajous-Navigatoren zu bestimmen, wird zunächst einer von ihnen als Referenz-Navigator und der andere als Ziel-Navigator festgelegt. Die Signalamplitude beider Lissajous-Navigatoren wird dann mit einer beliebigen Methode von der Lissajous-Trajektorie auf zum Beispiel ein reguläres Gitter auf einer Kugeloberfläche (Gitter aus Langen- und Breitengraden) interpoliert (siehe Fig. 2). Anschließend werden von beiden Datensätzen auf dem Gitter die Koeffizienten der Kugelflächenfunktionen (KFF) bis zu einem nutzergewählten Grad berechnet. Die Rotationsbestimmung aus den Navigatordaten erfolgt durch einen Algorithmus aus der Robotik, der sich ein Rotationstheorem der KFF zunutze macht (siehe z.B. Makadia, A. and Daniilidis, K.. Direct 3d-rotation estimation from spherical images via a generalized shift theorem, Proceedings of the 2003 IEEE Computer Society Conference on Computer Vision and Pattern Recognition 2:II-217, 2003 insbesondere die Kapitel 2 und 3 und Makadia, A., Sorgi, L. and Daniilidis, K .. Rotation estimation from spherical images, Proceedings of the 17th International Conference on Pattern Recognition, 2004 3:590-593, 2004 insbesondere die Kapitel 2 und 3). Das Rotationstheorem der KFF besagt, dass sich die Koeffizienten der KFF unter einer beliebigen Rotation g($\alpha$, $\beta$, $\gamma$) nach der bereits zuvor genannten Formel ändern:

$$\hat{f}_{lm}^g = e^{-im(\gamma+\pi/2)} \sum_{p=-l}^{l} e^{-ip(\alpha+\pi/2)} \hat{f}_{lp} \sum_{k=-l}^{l} e^{-ik(\beta+\pi)} P_l^{pk}(0) P_l^{km}(0)$$

Die Winkel $\alpha$, $\beta$ und $\gamma$ können anschließend durch die bereits zuvor beschriebene Optimierung

$$\min_{\alpha,\beta,\gamma} \left( \sum_{l=1}^{l_{\max}} \sum_{m=0}^{l} |\hat{f}_{lm}^g - \hat{f}_{lm}|^2 \right)$$

berechnet werden. Die Translationsbestimmung erfolgt in der zuvor beschriebenen Art und Weise.

Der Einsatz von sphärischen Lissajous-Navigatoren bei kleinen $k_r$ ermöglicht es, den gesamten Navigator in weniger als 8 ms mit nur einem einzigen Anregungspuls aufzunehmen. Die Messzeit ist somit erheblich kürzer als bei helikalen Spiral-Navigatoren, was ungewollte $T_2^*$-Effekte verringert. Zudem greift das Verfahren weniger in den Steady State der Hauptsequenz (Aufnahme von Bilddaten) ein als alle bisher in der Literatur bekannten helikalen Spiral-Navigatoren. Der beschriebene Algorithmus ist in der Lage genaue Rotationsparameter aus sphärischen Daten zu berechnen, die aufgrund des kleinen $k_r$ einen geringen Merkmalreichtum in der Signalamplitude oder Signalmagnitude haben. Aufgrund der Möglichkeit mit Lissajous-Navigatoren bei kleinen $k_r$ zu messen, ist das SNR überhaupt erst hoch genug um den zuvor beschriebenen Algorithmus anzuwenden. Bei niedrigem SNR liefert der Algorithmus keine zuverlässigen Ergebnisse. Hinzu kommt, dass dieser Algorithmus nur minimalem Rechenaufwand erfordert, was Echtzeit-Anwendungen ermöglicht.

Fig. 6 zeigt Ergebnisse einer Rotations- und Translationsbestimmung mittels einer Reihe von aufeinanderfolgenden sphärischer Lissajous-Navigatoren 70, die während eines MRT-Scans über die Zeit aufgenommen wurden, um Bewegungen des darzustellenden Objektes während des MRT-Scans zu bestimmen. Die Lissajous-Navigatoren sind durch einen k-Raum Radius $k_r$=0,1/cm, ne=11 und $n_\phi$=10 und $\delta_{nav}$=4.4ms gekennzeichnet. Es wurden 1100 Messpunkte zur Interpolation auf der Kugeloberfläche verwendet. Die Fig. 6 zeigt 5 Messungen eines menschlichen Kopfes unter realen Messbedingungen. Auf der linken Seite sind dabei die jeweiligen Rotationen [°] 63 und auf der rechten Seite die Translationen [mm] 65 dargestellt. Die durchgezogene Linien 64 stellen die Rotationen um die drei Rotationsachsen als Funktion der Zeit oder der aufeinanderfolgenden Navigatoren 70 dar. Die gestrichelten Linien 66 stellen die Translationen entlang der drei räumlichen Achsen als Funktion der Zeit oder der aufeinanderfolgenden Navigatoren 70 dar. Die fünf Messreihen zeigen (von oben nach unten) 0 bis 4 absichtliche Kopfbewegungen während des MRT-Scans. Die Messergebnisse zeigen, dass insbesondere die Rotationen 63 mit großer Genauigkeit bestimmt werden können. Zudem zeigen die Messergebnisse, dass die Translationsbewegungen so gering sind, dass die Translationen bei dem kleinen k-Raum Radius unmittelbar aus den Messdaten bestimmt werden können, wie zuvor diskutiert wurde.

Fig. 7 zeigt eine Prinzipskizze des Verfahrensablaufs. In Schritt 210 werden erste Koeffizienten von Kugelflächenfunktionen basierend auf ersten Navigatordaten des Objektes bestimmt, wobei die ersten Navigatordaten durch einen Magnetresonanztomographen mittels eines ersten sphärischen Lissajous-Navigators im k-Raum mit $k_r$<0,2/cm, bevorzugt $k_r$<0,15/cm und besonders bevorzugt $k_r$<0,1/cm aufgenommen werden, wobei $k_r$ den Absolutbetrag des Wellenvektors k bezeichnet. In Schritt 220 werden zweite Koeffizienten von Kugelflächenfunktionen basierend auf zweiten Navigatordaten des Objektes bestimmt, wobei die zweiten Navigatordaten durch einen Magnetresonanztomographen mittels eines zweiten sphärischen Lissajous-Navigators im k-Raum mit $k_r$<0,2/cm, bevorzugt $k_r$<0,15/cm und besonders bevorzugt $k_r$<0,1/cm aufgenommen werden. Die Berechnung einer Rotation des Objektes erfolgt in Schritt 230 mittels einer mathematischen Optimierung basierend auf den ersten Koeffizienten und den zweiten Koeffizienten.

Weitere Varianten der Erfindung und ihre Ausführung ergeben sich für den Fachmann aus der vorangegangenen Offenbarung, den Figuren und den Patentansprüchen.

In den Patentansprüchen verwendete Begriffe wie "umfassen", "aufweisen", "beinhalten", "enthalten" und dergleichen schließen weitere Elemente oder Schritte nicht aus. Die Verwendung des unbestimmten Artikels schließt eine Mehrzahl nicht aus. Eine einzelne Einrichtung kann die Funktionen mehrerer in den Patentansprüchen genannten Einheiten bzw. Einrichtungen ausführen. In den Patentansprüchen angegebene Bezugszeichen sind nicht als Beschränkungen der eingesetzten Mittel und Schritte anzusehen.

**Liste der Bezugszeichen**

| | |
|---|---|
| 10 | $k_x$[1/cm] |
| 20 | $k_y$[1/cm] |
| 30 | $k_z$[1/cm] |
| 40 | Zeit |
| 42 | sphärischer Lissajous-Navigator |
| 44 | Gx [mT/m] |
| 46 | $G_y$ [mT/m] |
| 48 | Gz [mT/m] |
| 50 | Signalamplitude [beliebige Einheit] |
| 55 | Karte der Signalamplitude eines sphärischen Navigators |
| 63 | Rotation [°] |
| 64 | Rotationen als Funktion der Zeit |
| 65 | Translation [mm] |
| 66 | Translationen als Funktion der Zeit |
| 70 | Navigatoren |
| 100 | Magnetresonanztomograph |
| 105 | Vorrichtung zur Erzeugung statischer Magnetfelder |

| 110 | Steuerung der Gradientenspulen |
|---|---|
| 114 | Gradientenspule |
| 120 | Hochfrequenzsteuerung |
| 122 | Hochfrequenzspule |
| 130 | Signalverarbeitungssystem |
| 135 | Empfangsspule |
| 150 | Steuersystem |
| 210 | Bestimmung erster Koeffizienten |
| 220 | Bestimmung zweiter Koeffizienten |
| 230 | Berechnung Objektrotation |

**Patentansprüche**

1. Verfahren zur Bestimmung von Bewegungen eines abzubildenden Objektes bei einem medizinischen Bildgebungsverfahren, das mindestens eine Magnetresonanztomographie beinhaltet, wobei das Verfahren die folgenden Schritte umfasst:

- Bestimmung erster Koeffizienten einer mathematischen Transformation basierend auf durch einen Magnetresonanztomographen (100) aufgenommenen ersten Navigatordaten des Objektes, wobei die ersten Navigatordaten Daten eines ersten sphärischen Lissajous-Navigators im k-Raum mit $k_r < 0,2/cm$, bevorzugt $k_r < 0,15/cm$ und besonders bevorzugt $k_r < 0,1/cm$ sind, wobei $k_r$ den Absolutbetrag des Wellenvektors k bezeichnet,
- Bestimmung zweiter Koeffizienten einer mathematischen Transformation basierend auf durch den Magnetresonanztomographen (100) aufgenommenen zweiten Navigatordaten des Objekts, wobei die zweiten Navigatordaten Daten eines zweiten sphärischen Lissajous-Navigators im k-Raum mit $k_r < 0,2/cm$, bevorzugt $k_r < 0,15/cm$ und besonders bevorzugt $k_r < 0,1/cm$ sind, wobei $k_r$ den Absolutbetrag des Wellenvektors k bezeichnet, wobei die ersten Koeffizienten erste Koeffizienten von Kugelflächenfunktionen sind, und wobei die zweiten Koeffizienten zweite Koeffizienten von Kugelflächenfunktionen sind, wobei die ersten Navigatordaten erste Signalamplituden umfassen, und die zweiten Navigatordaten zweite Signalamplituden umfassen, wobei die ersten Signalamplituden und die zweiten Signalamplituden jeweils auf ein reguläres Gitter oder auf beliebigen Punkten, wie insbesondere zufällig verteilt, auf einer Kugeloberfläche interpoliert werden,
- Berechnung einer Rotation des Objektes mittels einer mathematischen Optimierung basierend auf den ersten Koeffizienten und den zweiten Koeffizienten.

2. Das Verfahren gemäß Anspruch 1, wobei das Verfahren die weiteren Schritte umfasst:

- Aufnahme der erster Navigatordaten des Objektes durch den Magnetresonanztomographen (100),
- Aufnahme der zweiten Navigatordaten durch den Magnetresonanztomographen (100).

3. Das Verfahren gemäß einem der vorhergehenden Ansprüche, wobei der erste Lissajous-Navigator und der zweite Lissajous-Navigator durch die k-Raum-Trajektorie

$$k_x = k_r \sin(\omega_\theta t) * \cos(\omega_\phi t)$$

$$k_y = k_r \sin(\omega_\theta t) * \sin(\omega_\phi t)$$

$$k_z = k_r \cos(\omega_\theta t)$$

bestimmt sind, wobei t die Zeit ist und $\omega_\theta = n_\theta * 2*\pi/\delta_{nav}$ und $\omega_\phi = n_\phi * 2*\pi/\delta_{nav}$ sind, wobei $\delta_{nav}$ die Netto-Navigatordauer ist und $n_\theta$ und $n_\phi$ ganze Zahlen sind, wobei die Netto-Navigatordauer kleiner 20 ms, vorzugsweise kleiner 15 ms und besonders bevorzugt kleiner 10 ms ist, $n_\theta$ und $n_\phi$ zwischen 5 und 25 sind.

4. Das Verfahren gemäß einem der Ansprüche 1-3, wobei die Rotation des Objektes mittels eines Rotationtheorems der Kugelflächenfunktionen bestimmt wird.

**5.** Das Verfahren gemäß Anspruch 4, wobei die Rotation des Objektes derart bestimmt wird, dass die Rotation des Objektes mittels des Rotationstheorems die ersten Koeffizienten der Kugelflächenfunktionen optimal in die zweiten Koeffizienten der Kugelflächenfunktionen überführt.

**6.** Das Verfahren gemäß Anspruch 5, wobei die zweiten Koeffizienten der Kugelflächenfunktionen $\hat{f}_{lm}^{\,g}$ sich gemäß

$$\hat{f}_{lm}^{\,g} = e^{-im(\gamma+\pi/2)} \sum_{p=-l}^{l} e^{-ip(\alpha+\pi/2)}\, \hat{f}_{lp} \sum_{k=-l}^{l} e^{-ik(\beta+\pi)} P_{l}^{pk}(0) P_{l}^{km}(0)$$

aus den ersten Koeffizienten der Kugelflächenfunktionen $\hat{f}_{lm}$ ergeben, wobei die Winkel $\alpha$, $\beta$ und $\gamma$ Eulerwinkel in einer ZYZ-Konvention bezeichnen, $P_{l}^{km}(0)$ generalisierte assoziierte Legendre-Polynome bezeichnen und die Winkel $\alpha$, $\beta$ und $\gamma$ durch die Optimierung

$$\min_{\alpha,\beta,\gamma} \left( \sum_{l=1}^{l_{\max}} \sum_{m=0}^{l} |\,\hat{f}_{lm}^{\,g} - \hat{f}_{lm}|^2 \right)$$

berechnet werden.

**7.** Das Verfahren gemäß einem der vorhergehenden Ansprüche, wobei eine Translation des Objektes unmittelbar aus den ersten Navigatordaten und den zweiten Navigatordaten berechnet wird.

**8.** Das Verfahren gemäß einem der vorhergehenden Ansprüche 2 oder 3-7, sofern von Anspruch 2 abhängig, wobei zwischen der Aufnahme der ersten Navigatordaten und der zweiten Navigatordaten Bilddaten des Objektes durch den Magnetresonanztomographen (100) aufgenommen werden.

**9.** Das Verfahren gemäß einem der vorhergehenden Ansprüche, wobei ein Aufnahmebereich des Magnetresonanztomographen (100) in Abhängigkeit von der berechneten Rotation angepasst wird.

**10.** Ein Magnetresonanztomograph (100) umfassend eine Vorrichtung zur Erzeugung eines statischen Magnetfeldes (105), Gradientenspulen (114) sowie eine mit den Gradientenspulen (114) gekoppelte Steuerung der Gradientenspulen (110) zur Erzeugung eines zeitlich veränderlichen Magnetfeldgradienten, Hochfrequenzspulen (122) sowie eine mit den Hochfrequenzspulen (122) gekoppelte Hochfrequenzsteuerung (120) zur Erzeugung von Anregungsimpulsen, eine Empfangsspule (135), ein Signalverarbeitungssystem (130), das eingerichtet ist, von der Empfangsspule (135) empfangene Messdaten zu empfangen, sowie ein Steuersystem (150), das mit der Vorrichtung zur Erzeugung eines statischen Magnetfeldes (105), der Steuerung der Gradientenspulen (110), der Hochfrequenzsteuerung und dem Signalverarbeitungssystem gekoppelt ist, wobei der Magnetresonanztomograph (100) eingerichtet ist, erste Navigatordaten eines Objektes mittels eines ersten sphärischen Lissajous-Navigators im k-Raum mit $k_r<0{,}2/\text{cm}$, bevorzugt $k_r<0{,}15/\text{cm}$ und besonders bevorzugt $k_r<0{,}1/\text{cm}$ aufzunehmen, wobei $k_r$ den Absolutbetrag des Wellenvektors k bezeichnet, und erste Koeffizienten einer mathematischen Transformation basierend auf den ersten Navigatordaten zu bestimmen, wobei der Magnetresonanztomograph (100) eingerichtet ist, zweite Navigatordaten des Objektes mittels eines zweiten sphärischen Lissajous-Navigators im k-Raum mit $k_r<0{,}2/\text{cm}$, bevorzugt $k_r<0{,}15/\text{cm}$ und besonders bevorzugt $k_r<0{,}1/\text{cm}$ aufzunehmen und zweite Koeffizienten der mathematischen Transformation basierend auf den zweiten Navigatordaten zu bestimmen , und wobei der Magnetresonanztomograph (100) weiter eingerichtet ist,

eine Rotation des Objektes mittels einer mathematischen Optimierung basierend auf den ersten Koeffizienten und den zweiten Koeffizienten zu berechnen,
wobei die Hochfrequenzsteuerung (120) eingerichtet ist, mittels der Hochfrequenzspulen (122) mindestens einen Anregungspuls zur Aufnahme der ersten Navigatordaten und mindestens einen Anregungspuls zur Aufnahme der zweiten Navigatordaten zu erzeugen, wobei die Steuerung der Gradientenspulen (110) eingerichtet ist, mittels der Gradientenspulen (114) den ersten und den zweiten sphärischen Lissajous-Navigator zur Aufnahme der ersten und der zweiten Navigatordaten zu erzeugen, wobei die Empfangsspule eingerichtet ist, die ersten und die zweiten Navigatordaten aufzunehmen, wobei die ersten Navigatordaten erste Signalamplituden umfassen, und die zweiten Navigatordaten zweite Signalamplituden umfassen, wobei das Signalverarbeitungssystem (130) eingerichtet ist die ersten Navigatordaten und die zweiten Navigatordaten von der Empfangsspule (135) zu empfangen, wobei das Signalverarbeitungssystem (130) eingerichtet ist, die ersten Signalamplituden und die zweiten Signalamplituden jeweils auf ein reguläres Gitter oder auf beliebigen Punkten, wie insbesondere zufällig verteilt, auf einer Kugeloberfläche zu interpolieren, wobei das Signalverarbeitungssystem (130) eingerichtet ist, die ersten Koeffizienten mittels der ersten Signalamplituden zu berechnen, wobei die ersten Koeffizienten erste Koeffizienten von Kugelflächenfunktionen sind, und wobei das Signalverarbeitungssystem (130) eingerichtet ist, die zweiten Koeffizienten mittels der zweiten Signalamplituden zu berechnen, wobei die zweiten Koeffizienten zweite Koeffizienten von Kugelflächenfunktionen sind.

**11.** Der Magnetresonanztomograph (100) gemäß Anspruch 10, wobei der Magnetresonanztomograph (100) eingerichtet ist, einen Aufnahmebereich zur Bestimmung von Bilddaten des Objektes in Abhängigkeit von der berechneten Rotation anzupassen.

**12.** Ein Computerprogrammprodukt umfassend Computer-Code-Mittel, die in einem Speicher des Magnetresonanztomographen (100) gemäß einem der Ansprüche 10 oder 11 oder eines Auswertungsrechners gespeichert werden können, wobei die Computer-Code-Mittel derart ausgestaltet sind, dass sie die Ausführung der Verfahrensschritte des Verfahrens gemäß einem der Ansprüche 1-9 auf einem Prozessor des Magnetresonanztomographen (100) gemäß einem der Ansprüche 10 oder 11 bzw. die Verfahrensschritte gemäss Anspruch 1 auf dem Auswertungsrechner bewirken.

**Claims**

**1.** A method for determining movements of an object to be imaged in a medical imaging method which includes at least one magnetic resonance imaging, the method comprising the following steps:

- determining first coefficients of a mathematical transformation based on first navigator data of the object recorded by a magnetic resonance scanner, wherein the first navigator data are recorded by a magnetic resonance tomograph (100), the first navigator data being data of a first spherical Lissajous navigator in the k-space with $k_r<0.2/cm$, preferably $k_r<0.15/cm$, and particularly preferred $k_r<0.1/cm$, wherein $k_r$ represents the absolute value of the wave vector **k,**
- determining second coefficients of a mathematical transformation based on second navigator data of the object recorded by the magnetic resonance tomograph (100), the second navigator being data of a second spherical Lissajous navigator in the k-space with $k_r<0.2/cm$, preferably $k_r<0.15/cm$, and particularly preferred $k_r<0.1/cm$, wherein $k_r$ represents the absolute value of the wave vector **k,** wherein the first coefficients are first coefficients of spherical harmonics, and the second coefficients are second coefficients of spherical harmonics, wherein the first navigator data comprise first signal amplitudes, and the second navigator data comprise second signal amplitudes, wherein the first signal amplitudes and the second signal amplitudes are each interpolated to a regular grid or to any points, such as in particular randomly distributed, on a spherical surface,
- calculating a rotation of the object using a mathematical optimization based on the first coefficients and the second coefficients.

**2.** The method according to claim 1, the method comprising the following further steps:

- recording the first navigator data of the object by the magnetic resonance tomograph (100),
- recording the second navigator data by the magnetic resonance tomograph (100).

**3.** The method according to any one of the preceding claims, wherein the first Lissajous navigator and the second Lissajous navigator are determined by the k-space trajectory

$$k_x = k_r \sin(\omega_\theta t) * \cos(\omega_\phi t)$$

$$k_y = k_r \sin(\omega_\theta t) * \sin(\omega_\phi t)$$

$$k_z = k_r \cos(\omega_\theta t)$$

wherein t is the time and $\omega_\theta = n_\theta * 2 * \pi / \delta_{nav}$ and $\omega_\phi = n_\phi * 2 * \pi / \delta_{nav}$, wherein $\delta_{nav}$ is the net navigator duration and $n_\theta$ and $n_\phi$ are integrals, wherein the net navigator duration is less than 20 ms, preferably less than 15 ms, and particularly preferred less than 10 ms, and wherein $n_\theta$ and $n_\phi$ are between 5 and 25.

4. The method according to any one of claims 1-3, wherein the rotation of the object is determined by a rotation theorem of the spherical harmonics.

5. The method according to claim 4, wherein the rotation of the object is determined such that the rotation of the object converts the first coefficients of the spherical harmonics optimally into the second coefficients of the spherical harmonics by means of the rotation theorem.

6. The method according to claim 5, wherein the second coefficients of the spherical harmonics $\hat{f}_{lm}^{\,g}$ result according to

$$\hat{f}_{lm}^{\,g} = e^{-im(\gamma + \pi/2)} \sum_{p=-l}^{l} e^{-ip(\alpha + \pi/2)} \, \hat{f}_{lp} \sum_{k=-l}^{l} e^{-ik(\beta + \pi)} \, P_l^{pk}(0) \, P_l^{km}(0)$$

from the first coefficients of the spherical harmonics $\hat{f}_{lm}$, wherein the angles $\alpha$, $\beta$ and $\gamma$ refer to Euler angles in a ZYZ convention, $P_l^{km}(0)$ refer to generalized associated Legendre polynomials, and the angles $\alpha$, $\beta$ and $\gamma$ are calculated by the optimization

$$\min_{\alpha, \beta, \gamma} \left( \sum_{l=1}^{l_{\max}} \sum_{m=0}^{l} \left| \hat{f}_{lm}^{\,g} - \hat{f}_{lm} \right|^2 \right).$$

7. The method according to any one of the preceding claims, wherein a translation of the object is calculated directly from the first navigator data and the second navigator data.

8. The method according to any one of the preceding claims 2 or 3-7, if dependent on claim 2, wherein between recording the first navigator data and the second navigator data, image data of the object are recorded by the magnetic resonance tomograph (100).

9. The method according to any one of the preceding claims, wherein a recording area of the magnetic resonance tomograph (100) is adjusted depending on the calculated rotation.

10. A magnetic resonance tomograph (100) comprising a device for generating a static magnetic field (105), gradient coils (114) as wells as a control of the gradient coils (110) coupled to the gradient coils (114) for generating a temporally variable magnetic field gradient, high-frequency coils (122) as well as a high-frequency control (120) coupled to the high-frequency coils (122) for generating excitation pulses, a receiving coil (135), a signal processing system (130) configured to receive measuring data from the receiving coil (135), as well as a control system (150) coupled to the device for generating the static magnetic field (105), the controller of the gradient coils (110), the high-frequency control and the signal processing system, wherein the magnetic resonance tomograph (100) is configured to record first navigator data of the object using a first spherical Lissajous navigator in the k-space with $k_r < 0.2$/cm, preferably $k_r < 0.15$/cm and particularly preferred $k_r < 0.1$/cm, wherein $k_r$ refers to the absolute value of the wave vector **k**, and to determine first coefficients of a mathematical transformation based on the first navigator data, wherein the magnetic resonance tomograph (100) is further configured to record second navigator data of the object using a second spherical Lissajous navigator in the k-space with $k_r<0.2/cm$, preferably $k_r<0.15/cm$ and particularly preferred $k_r<0.1/cm$, and to determine second coefficients of the mathematical transformation based on the second navigator data, and wherein the magnetic resonance tomograph (100) is further configured to calculate a rotation of the object using a mathematical optimization based on the first coefficients and the second coefficients, wherein the high-frequency control (120) is configured to generate, by means of the high-frequency-coils (122), at least one excitation pulse for recording the first navigator data and at least one excitation pulse for recording the second navigator data, wherein the control of the gradient coils (110) is preferably configured to generate, by means of the gradient coils (114), the first and the second spherical Lissajous navigator for recording the first and the second navigator data, wherein the receiving coil is configured to record the first and the second navigator data, wherein the first navigator data comprise first signal amplitudes and the second navigator data comprise second signal amplitudes, wherein the signal processing system (130) is configured to receive the first navigator data and the second navigator data from the receiving coil (135), wherein the signal processing system (130) is configured to interpole the first signal amplitudes and the second signal amplitudes respectively to a regular grid or any point, such as in particular randomly distributed, on a spherical surface, wherein the signal processing system (130) is configured to calculate the first coefficients by means of the first signal amplitudes, wherein the first coefficients are first coefficients of spherical harmonics, and wherein the signal processing system (130) is configured to calculate the second coefficients of by means of the second signal amplitudes, wherein the second coefficients are second coefficients of spherical harmonics.

11. The magnetic resonance tomograph (100) according to claim 10, wherein the magnetic resonance tomograph (100) is configured to adjust a recording area for determining image data of the object depending on the calculated rotation.

12. A computer program comprising computer code means adapted to be stored in a storage of the magnetic resonance tomograph (100) according to any one of claims 10 or 11 or of an evaluation computer, wherein the computer code means are configured such that they cause the method steps of the method according to any one of claims 1-9 to be performed on a processor of the magnetic resonance tomograph (100) according to any one of claims 10 or 11 or cause the method steps according to claim 1 to be performed on the evaluation computer, respectively.

**Revendications**

1. Procédé de détermination de mouvements d'un objet à imager dans un procédé d'imagerie médicale, lequel contient au moins une tomographie par résonance magnétique, dans lequel le procédé comprend les étapes suivantes :

   - détermination de premiers coefficients d'une transformation mathématique basée sur des premières données de navigateur de l'objet enregistrées par un tomographe à résonance magnétique (100), dans lequel les premières données de navigateur sont des données d'un premier navigateur sphérique de Lissajous dans l'espace k avec $k_r<0,2/cm$, de préférence $k_r<0,15/cm$ et tout particulièrement $k_r<0,1/cm$, dans lequel $k_r$ désigne la valeur absolue du vecteur d'onde k,
   - détermination de deuxièmes coefficients d'une transformation mathématique basée sur des deuxièmes données de navigateur de l'objet enregistrées par le tomographe à résonance magnétique (100), dans lequel les deuxièmes données de navigateur sont des données d'un deuxième navigateur sphérique de Lissajous dans l'espace k avec kr<0,2/cm, de préférence kr<0,15/cm et tout particulièrement kr<0,1/cm, dans lequel kr désigne la valeur absolue du vecteur d'onde k, dans lequel les premiers coefficients sont des premiers coefficients d'harmonies sphériques, et dans lequel les deuxièmes coefficients sont des deuxièmes coefficients d'harmonies sphériques, dans lequel les premières données de navigateur comprennent des premières amplitudes de signal et les deuxièmes données de navigateur comprennent des deuxièmes amplitudes de signal, dans lequel les premières amplitudes de signal et les deuxièmes amplitudes de signal sont interpolées sur une grille régulière ou sur des points arbitraires, en particulier distribués aléatoirement, sur une surface sphérique,
   - calcul d'une rotation de l'objet au moyen d'une optimisation mathématique basée sur les premiers coefficients et les deuxièmes coefficients.

2. Procédé selon la revendication 1, dans lequel le procédé comprend les étapes ultérieures :

   - enregistrement des premières données de navigateur de l'objet par le tomographe à résonance magnétique (100),
   - enregistrement des deuxièmes données de navigateur de l'objet par le tomographe à résonance magnétique (100).

3. Procédé selon l'une des revendications précédentes, dans lequel le premier navigateur de Lissajous et le deuxième navigateur de Lissajous sont déterminés par la trajectoire d'espace k

$$k_x = k_r \sin(\omega_\theta t) * \cos(\omega_\phi t)$$

$$k_y = k_r \sin(\omega_\theta t) * \sin(\omega_\phi t)$$

$$k_z = k_r \cos(\omega_\theta t)$$

dans lequel t est le temps et on a $\omega_\theta = n_\theta * 2 * \pi / \delta_{nav}$ et $\omega_\phi = n_\phi * 2 * \pi / \delta_{nav}$, dans lequel $\delta_{nav}$ est la durée nette du navigateur et $n_\theta$ et $n_\phi$ sont des entiers, dans lequel la durée nette du navigateur est inférieure à 20 ms, de préférence inférieure à 15 ms et tout particulièrement inférieure à 10 ms, $n_\theta$ et $n_\phi$ sont compris entre 5 et 25.

4. Procédé selon l'une des revendications 1 à 3, dans lequel la rotation de l'objet est déterminée au moyen d'un théorème de rotation des harmonies sphériques.

5. Procédé selon la revendication 4, dans lequel la rotation de l'objet est déterminée de telle sorte que la rotation de l'objet convertit de manière optimale les premiers coefficients des harmonies sphériques en les deuxièmes coefficients des harmonies sphériques au moyen du théorème de rotation.

6. Procédé selon la revendication 5, dans lequel les deuxièmes coefficients des harmonies sphériques $\hat{f}_{lm}^g$ s'obtiennent à partir des premiers coefficients des harmonies sphériques $\hat{f}_{lm}$ selon

$$\hat{f}_{lm}^g = e^{-im(\gamma + \pi/2)} \sum_{p=-l}^{l} e^{-ip(\alpha + \pi/2)} \hat{f}_{lp} \sum_{k=-l}^{l} e^{-ik(\beta + \pi)} P_l^{pk}(0) P_l^{km}(0)$$

dans lequel les angles $\alpha$, $\beta$ et $\gamma$ désignent des angles d'Euler dans un référentiel ZYZ, $P_l^{km}(0)$ désignent les polynômes de Legendre généralisés associés et les angles $\alpha$, $\beta$ et $\gamma$ sont calculés par l'optimisation

$$\min_{\alpha,\beta,\gamma} \left( \sum_{l=1}^{l_{max}} \sum_{m=0}^{l} |\hat{f}_{lm}^g - \hat{f}_{lm}|^2 \right)$$

7. Procédé selon l'une des revendications précédentes, dans lequel une translation de l'objet est calculée directement à partir des premières données de navigateur et des deuxièmes données de navigateur.

8. Procédé selon l'une des revendications précédentes 2 ou 3-7 pour autant qu'elle dépende de la revendication 2, dans lequel des données d'image de l'objet sont enregistrées par le tomographe à résonance magnétique (100) entre l'enregistrement des premières données de navigateur et deuxièmes données de navigateur.

9. Procédé selon l'une des revendications précédentes, dans lequel une zone d'enregistrement du tomographe à résonance magnétique (100) est adaptée en fonction de la rotation calculée.

10. Tomographe à résonance magnétique (100) comprenant un dispositif destiné à générer un champ magnétique statique (105), des bobines de gradient (114) ainsi qu'une commande des bobines de gradient (110) couplée aux bobines de gradient (114) destinées à générer un gradient de champ de champ magnétique changeant dans le temps, des bobines haute fréquence (122) ainsi qu'une commande haute fréquence (120) couplée aux bobines haute fréquence (122) destinée à générer des impulsions d'excitation, une bobine réceptrice (135), un système de traitement du signal (130), lequel est disposé pour recevoir des données de mesures reçues par la bobine réceptrice (135), ainsi qu'un système de commande (150), lequel est couplé au dispositif de génération de champ magnétique statique (105), à la commande des bobines de gradient (110), à la commande haute fréquence et au système de traitement du signal, dans lequel le tomographe à résonance magnétique (100) est disposé afin d'enregistrer des premières données de navigateur d'un objet au moyen d'un premier navigateur sphérique de Lissajous dans l'espace k avec $k_r<0,2$/cm, de préférence $k_r<0,15$/cm et tout particulièrement $k_r<0,1$/cm, dans lequel $k_r$ désigne la valeur absolue du vecteur d'onde **k,** et afin de déterminer les premiers coefficients d'une transformation mathématique basée sur les premières données de navigateur, dans lequel le tomographe à résonance magnétique (100) est disposé afin d'enregistrer des deuxièmes données de navigateur de l'objet au moyen d'un deuxième navigateur sphérique de Lissajous dans l'espace k avec $k_r<0,2$/cm, de préférence $k_r<0,15$/cm et tout particulièrement $k_r<0,1$/cm, et afin de déterminer les deuxièmes coefficients de la transformation mathématique basée sur les deuxièmes données de navigateur, et dans lequel le tomographe à résonance magnétique (100) est en outre disposé pour calculer une rotation de l'objet au moyen d'une optimisation mathématique basée sur les premiers coefficients et les deuxièmes coefficients, dans lequel la commande haute fréquence (120) est disposée afin de générer au moyen des bobines haute fréquence (122) au moins une impulsion d'excitation destinée à enregistrer les premières données de navigateur et au moins une impulsion d'excitation destinée à enregistrer les deuxièmes données de navigateur, dans lequel la commande des bobines de gradient (110) est disposée afin de générer au moyen des bobines de gradient (114) le premier et le deuxième navigateur sphérique de Lissajous destinés à enregistrer les premières et les deuxièmes données de navigateur, dans lequel la bobine réceptrice est disposée afin d'enregistrer les premières et les deuxièmes données de navigateur, dans lequel les premières données de navigateur comprennent des premières amplitudes de signal et les deuxièmes données de navigateur comprennent des deuxièmes amplitudes de signal, dans lequel le système de traitement de signal (130) est disposé afin de recevoir les premières données de navigateur et les deuxièmes données de navigateur depuis la bobine réceptrice (135), dans lequel le système de traitement de signal (130) est disposé afin d'interpoler les premières amplitudes de signal et les deuxièmes amplitudes de signal sur une grille régulière ou sur des points arbitraires, en particulier distribués aléatoirement, sur une surface sphérique, dans lequel le système de traitement de signal (130) est disposé afin de calculer les premiers coefficients au moyen des premières amplitudes de signal, dans lequel les premiers coefficients sont des premiers coefficients d'harmonies sphériques, et dans lequel le système de traitement de signal (130) est disposé afin de calculer les deuxièmes coefficients au moyen des deuxièmes amplitudes de signal, dans lequel les deuxièmes coefficients sont des deuxièmes coefficients d'harmonies sphériques.

11. Tomographe à résonance magnétique (100) selon la revendication 10, dans lequel le tomographe à résonance magnétique (100) est disposé afin d'adapter une zone d'enregistrement destinée à la détermination de données d'image de l'objet en fonction de la rotation calculée.

12. Produit-programme informatique doté de moyens de code informatique, pouvant être mémorisé dans une mémoire du tomographe à résonance magnétique (100) selon l'une des revendications 10 ou 11 ou d'un ordinateur d'analyse, dans lequel les moyens de code informatique sont configurés de telle sorte qu'ils opèrent l'exécution des étapes du procédé selon l'une des revendications 1-9 sur un processeur du tomographe à résonance magnétique (100) selon l'une des revendications 10 ou 11 ou les étapes de procédé selon la revendication 1 sur l'ordinateur d'analyse.

EP 3 803 432 B1

**Fig. 1**

**Fig. 2**

Fig. 3

**Fig. 4**

**Fig. 5**

EP 3 803 432 B1

Fig. 6

Fig. 7

22

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **WELCH, E.B. ; MANDUCA, A. ; GRIMM, R.C. ; WARD, H.A. ; JACK JR, C.R .** Spherical navigator echoes for full 3D rigid body motion measurement in MRI. *Magnetic Resonance in Medicine,* 2002, vol. 47, 32-41
- **MARCUS GÖRGE ULLISCH.** Eine navigator-basierte Methode zur Bewegungskorrektur starrer Körper in der Magnet-Resonanz-Tomographie. *Dissertation,* 2012, http://publications.rwth-aachen.de/record/82888?ln=de
- **YEN Y-F.** 3D Rotation Matching Using Spherical Harmonic Transformation of k-Space Navigator, Proceedings of the International Society for magnetic resonance in medicine. *12th Scientific Meeting & Exhibition,* 15. Mai 2004, 2154
- **WELCH et al.** *Determination of Translation,* 33

- **PHINNEY RA ; BURRIDGE R.** Representation of the elastic-gravitational excitation of a spherical earth model by generalized spherical harmonics. *Geophysical Journal International,* 1973, vol. 34, 451-487
- **MICHAEL A MORRISON ; GREGORY A PARKER.** A Guide to Rotations in Quantum Mechanics. *Australian journal of physics,* 1987, vol. 40 (4), 465-498
- **MAKADIA, A. ; DANIILIDIS, K.** Direct 3d-rotation estimation from spherical images via a generalized shift theorem. *Proceedings of the 2003 IEEE Computer Society Conference on Computer Vision and Pattern Recognition,* 2003, vol. 2, II-217
- **MAKADIA, A. ; SORGI, L. ; DANIILIDIS, K .** Rotation estimation from spherical images. *Proceedings of the 17th International Conference on Pattern Recognition,* 2004, vol. 3, 590-593